(19) Europäisches Patentamt
European Patent Office
Office européen des brevets

(11) **EP 2 092 581 B1**

(12) **FASCICULE DE BREVET EUROPEEN**

(45) Date de publication et mention de la délivrance du brevet:
**05.12.2018 Bulletin 2018/49**

(21) Numéro de dépôt: **07857889.5**

(22) Date de dépôt: **19.12.2007**

(51) Int Cl.:
***H01L 51/52*** *(2006.01)*

(86) Numéro de dépôt international:
**PCT/EP2007/064268**

(87) Numéro de publication internationale:
**WO 2008/074847 (26.06.2008 Gazette 2008/26)**

(54) **DIODE ORGANIQUE ELECTROLUMINESCENTE AYANT UNE COUCHE BARRIERE EN MATERIAU BIPOLAIRE**

ORGANISCHE LEUCHTDIODE MIT SPERRSCHICHT AUS BIPOLAREM MATERIAL

ORGANIC LIGHT-EMITTING DIODE HAVING A BARRIER LAYER MADE OF BIPOLAR MATERIAL

(84) Etats contractants désignés:
AT BE BG CH CY CZ DE DK EE ES FI FR GB GR HU IE IS IT LI LT LU LV MC MT NL PL PT RO SE SI SK TR

(30) Priorité: **20.12.2006 FR 0655671**

(43) Date de publication de la demande:
**26.08.2009 Bulletin 2009/35**

(73) Titulaire: **Thomson Licensing
92130 Issy-les-Moulineaux (FR)**

(72) Inventeurs:
• **MAINDRON, Tony
35530 Noyal-sur-Vilaine (FR)**
• **VAUFREY, David
38000 Grenoble (FR)**
• **LE CLOAREC, Hélène
38000 Grenoble (FR)**

(74) Mandataire: **Browaeys, Jean-Philippe et al
InterDigital CE Patent Holdings
1-5, Rue Jeanne d'Arc
92130 Issy-les-Moulineaux (FR)**

(56) Documents cités:
WO-A-02/41414          WO-A-2004/075603
JP-A- 10 152 677       US-A1- 2006 131 562
US-A1- 2006 166 036

• MAINDRON T ET AL: "Highly electroluminescent devices made with a conveniently synthesized triazole-triphenylamine derivative" PREPARATION AND CHARACTERIZATION, ELSEVIER SEQUOIA, NL, vol. 466, no. 1-2, 1 novembre 2004 (2004-11-01), pages 209-216, XP004552753 ISSN: 0040-6090 cité dans la demande

**Description**

L'invention concerne une diode organique électroluminescente (OLED) comprenant une électrode inférieure et une électrode supérieure, l'une desdites électrodes servant d'anode et l'autre servant de cathode, et une couche organique électroluminescente intercalée entre ces deux électrodes. De telles diodes, émettant dans le rouge, le vert et le bleu, servent notamment à la fabrication de panneaux d'affichage d'images en couleur.

Le principe de fonctionnement de telles diodes repose sur l'injection d'électrons dans la couche organique électroluminescente par la cathode et l'injection de trous dans la couche organique électroluminescente par l'anode ; la recombinaison des électrons et des trous injectés dans la couche organique électroluminescente produit alors un rayonnement électromagnétique.

En pratique, il importe d'éviter que les trous injectés par l'anode ne traversent dans un sens la couche organique électroluminescente avant d'avoir été recombinés à des électrons, et d'éviter que les électrons injectés par la cathode ne traversent dans l'autre sens la couche organique électroluminescente avant d'avoir été recombinés à des trous ; à cet effet, généralement, la diode organique électroluminescente comprend également :

- une couche organique de blocage de trous, au contact de la couche électroluminescente et intercalée entre cette couche électroluminescente et l'électrode servant de cathode ;
- et/ou une couche organique de blocage d'électrons, au contact de la couche électroluminescente et intercalée entre cette couche électroluminescente et l'électrode servant d'anode.

Si l'on appelle $E_{EL-V}$ le potentiel d'ionisation ou l'énergie du niveau du HOMO du matériau de base de la couche organique électroluminescente, et $E_{HBL-V}$ le potentiel d'ionisation ou l'énergie du niveau du HOMO du matériau de base de la couche organique de blocage de trous, ces potentiels étant évalués positivement par rapport à l'énergie d'un électron dans le vide à l'infini, on a alors $E_{BP-V} > E_{EL-V}$, ce qui signifie qu'on crée une barrière de potentiel pour les trous à l'interface entre la couche organique électroluminescente et la couche organique de blocage de trous.

Si l'on appelle $E_{EL-C}$ l'affinité électronique ou l'énergie du niveau du LUMO du matériau de base de la couche organique électroluminescente, et $E_{EBL-C}$ l'affinité électronique ou l'énergie du niveau du LUMO du matériau de base de la couche organique de blocage des électrons, ces potentiels étant évalués positivement par rapport à l'énergie d'un électron dans le vide à l'infini, on a alors $E_{EBL-C} < E_{EL-C}$, ce qui signifie qu'on crée une barrière de potentiel pour les électrons à l'interface entre la couche organique électroluminescente et la couche organique de blocage d'électrons.

Ainsi, les structures des diodes OLED utilisées dans la réalisation des panneaux d'affichage font intervenir en général des couches de blocages de charges de part et d'autre des couches électroluminescentes émettant tant dans le rouge, le vert ou le bleu. Le rôle de ces couches de blocage est donc de confiner les charges, électrons et trous, au sein de la couche émettrice afin d'augmenter la probabilité de recombinaison des électrons et des trous dans cette couche émettrice, et donc d'améliorer le rendement quantique des diodes. Le matériau de base d'une couche de blocage de trous, de type BPhen par exemple, est un bon transporteur d'électrons mais généralement un très mauvais transporteur de trous. En outre, son potentiel d'ionisation ou niveau HOMO est généralement élevé (6.2 eV dans le cas du BPhen) afin de bloquer efficacement les trous.

On a récemment découvert que le matériau de base des couches électroluminescente pouvait être dégradé sous l'effet de l'accumulation de charges aux interfaces de la couche électroluminescente avec les couches de blocages (trous du côté de la cathode, électrons du côté de l'anode) ; dans un article de la revue « Science », 283, 5409, pages 1900-1902 (1999), une équipe de la société Xerox a ainsi montré la dégradation « intrinsèque » de la molécule d'AIQ3 (tris-8-quinolinolato-aluminum) lorsque celle-ci, dans une structure de type OLED, est traversée par un courant de charges positives ; cette dégradation a été attribuée à l'instabilité du radical cationique AIQ3+ ; on en a déduit que la molécule d'AIQ3, réputée pour le transport d'électrons, préfère être enrichie en charges négatives, car le radical anionique AIQ3- est stable, qu'en charges positives, car le radical cationique AIQ3+ est instable ; pratiquement, il semble que le radical cationique AIQ3+ réduise le temps de vie des espèces excitoniques AIQ3* à cause des sous produits de dégradation générés par sa réactivité qui agissent comme des inhibiteurs de fluorescence (« fluorescence quencher » en langue anglaise). Dans une structure électroluminescente classique à base de NPB/AIQ3, il a aussi été montré que ces espèces excitoniques AIQ3* créaient en outre des niveaux « pièges » pour les charges à l'interface entre le matériau NPB et le matériau AIQ3 et agissaient comme centres de recombinaison non radiative entre les électrons et les trous (voir aussi Aziz, H.; Popovic, Z. D.Chem. Mater.; (Review); 2004; 16(23); 4522-4532). Une telle instabilité et de tels niveaux « pièges » sont alors autant de sources de dégradation par inhibition (« quenching » en langue anglaise) de la luminescence, qui entraînent une baisse sensible du rendement de la diode et de sa durée de vie.

Dans le cas d'une diode émettant dans le bleu, où les matériaux des différentes couches organiques présentent donc une large bande interdite (« gap » en langue anglaise), on a constaté que le confinement des trous dans la couche organique électroluminescente générait des radicaux ionisés instables entraînant la formation de sous-produits de dégradation générant à leur tour des niveaux d'énergie intermédiaires situés dans le gap du matériau de la couche organique électroluminescente. De tels niveaux d'énergie intermédiaires sont alors autant de sources de dégradation par extinction (« quenching » en langue anglaise) de la luminescence, qui entraînent une baisse sensible du rendement de la diode.

Un but de l'invention est d'offrir un nouveau mode de blocage pour le confinement des charges, non plus par barrière de potentiel exclusivement, qui permette de limiter la dégradation et l'accumulation de charges aux interfaces de la couche électroluminescente avec les couches de blocages.

Un principe général de l'invention consiste à remplacer la couche de blocage, notamment de blocage de trous, par une couche en matériau organique bipolaire, possédant à la fois un groupement de type accepteur et un groupement de type donneur. En premier lieu, en utilisant une molécule bipolaire pour le matériau de base de la couche au contact de la couche électroluminescente, on limite la formation de charges excédentaires à l'interface de la couche électroluminescente avec la couche adjacente bipolaire, tout en évacuant de la couche électroluminescente les charges qui seraient en excès, via cette couche adjacente bipolaire. En deuxième lieu, la fonction de blocage de charges est alors assurée non plus tant par une barrière de potentiel à cette interface, mais par une différence de mobilité des charges au sein du matériau organique bipolaire : si cette couche est du côté de la cathode, le blocage des trous sera assuré notamment par une mobilité plus faible des trous que des électrons ; si cette couche est du côté de l'anode, le blocage des trous sera assuré notamment par une mobilité plus faible des électrons que des trous.

Mobilité et conductivité sont deux propriétés différentes d'un matériau. La conductivité $\sigma_e$ apportée par les électrons relie le champ électrique E auquel est soumis le matériau à la densité de courant $J_e$ (A/m$^2$) selon la relation : $J_e = \sigma_e \times E$. La mobilité $\mu_e$ apportée par les électrons relie également le champ électrique E auquel est soumis le matériau à la densité de courant $J_e$ (A/m$^2$) selon une autre relation qui fait intervenir la densité d'électrons $d_e$ : $J_e = \mu_e \times n_e \times E$. Le même raisonnement vaut pour les trous. Ainsi, la mobilité des électrons ou des trous est une propriété intrinsèque au matériau, alors que la conductivité fait intervenir la densité de porteurs au sein de ce matériau, c'est-à-dire notamment, pour un semi-conducteur, le niveau de dopage, de type n pour les électrons et de type p pour les trous.

On connaît par ailleurs des diodes organiques comprenant une couche organique de transport de charges, électrons ou trous, au contact de la couche électroluminescente et intercalée entre cette couche électroluminescente et l'une des électrodes ; les documents EP1065737, EP1220340, US5895692, et l'article intitulé « Organic light-emitting diodes with a bipolar transport layer », de Vi-En Choong et al., publié le 12 juillet 1999 dans la revue Applied Physics Letters - volume 75, numéro 2, pp. 172-174, divulguent de telles diodes. Il est à noter que ces couches de transport en matériau bipolaire n'ont aucune fonction de blocage de charges. Dans le document EP1670083, on décrit une couche organique bipolaire intercalée entre une couche organique fluorescente et une couche organique phosphorescente qui n'a, a priori, aucune fonction de blocage de charges. Même dans le document US2004-265624, on n'obtient pas cette double fonction de blocage modéré des trous et de redistribution de ces trous car les matériaux (BAIQ, BPhen, TAZ, etc...) utilisés dans les couches au contact de la couche électroluminescente présentent tous un niveau HOMO tellement supérieur à celui de la couche électroluminescente qu'on obtient la fonction classique de blocage essentiellement par barrière de potentiel comme dans l'art antérieur. Le document WO2004/075603 décrit une couche de blocage de trous en matériau « B-60 », qui est, selon ce document, un dérivé d'anthracène (l'anthracène est connu pour être un matériau bipolaire), mais, là aussi, rien n'indique que la fonction de blocage des trous soit obtenue par un effet de différence de mobilité comme dans l'invention, et non pas essentiellement par un effet de barrière de potentiel comme dans l'art antérieur. Même si la conductivité de ce matériau « B-60 » est plus faible pour les trous que pour les électrons, cette couche de blocage étant située du côté cathodique, rien n'indique que, dans ce matériau « B-60 », la mobilité des trous soit inférieure à celle des électrons. L'invention se distingue également des diodes décrites dans le document US2006-131562, où toutes les couches organiques sont à base du même matériau bipolaire.

Le document JP10152677 divulgue déjà une diode électroluminescente organique avec une couche électroluminescente et une couche comprenant un dérivé TAZ-TPA.

Plus précisément, l'invention a pour objet une diode organique électroluminescente décrite dans la revendication 1 et comprenant une électrode inférieure et une électrode supérieure, l'une desdites électrodes servant d'anode et l'autre servant de cathode, au moins une couche organique électroluminescente intercalée entre ces deux électrodes, au moins une couche organique bipolaire qui est au contact d'au moins une des faces de l'au moins une couche électroluminescente et qui est intercalée entre cette couche électroluminescente et l'une desdites électrodes, et une couche organique de transport de charges qui est intercalée entre ladite électrode et l'au moins une couche organique bipolaire, et qui est de préférence au contact de ladite électrode.

La molécule élémentaire du matériau de base de l'au moins une couche organique bipolaire est bipolaire en ce sens qu'elle possède à la fois un groupement de type accepteur d'électrons et un groupement de type donneur d'électrons ; grâce à son groupement accepteur, cette molécule présente donc un pouvoir oxydant, et grâce à son groupement donneur, cette molécule présente donc un pouvoir réducteur ; à noter que des matériaux classiques comme AIQ3 ou NPB ne sont pas considérés comme bipolaires, même si ses matériaux présentent une mobilité mesurable à la fois pour les électrons et pour les trous ; en effet, les molécules élémentaires de ces matériaux ne possèdent pas à la fois un groupement de type accepteur et un groupement de type donneur.

Selon l'invention :

- si ladite couche organique bipolaire est intercalée entre ladite couche électroluminescente avec laquelle elle est en contact et l'électrode servant de cathode, alors le matériau de base de ladite couche organique bipolaire présente une mobilité plus faible pour les trous que pour les électrons ;
- et/ou si ladite couche organique bipolaire est intercalée entre ladite couche électroluminescente avec laquelle elle est en contact et l'électrode servant d'anode, alors le matériau de base de ladite couche organique bipolaire présente une mobilité plus faible pour les électrons que pour les trous.

Selon l'invention, la fonction de blocage des charges est alors assurée par une différence de mobilité - intrinsèque - adaptée entre les trous et les électrons, et non plus uniquement par une barrière de potentiel comme dans l'art antérieur. De préférence, le matériau de base de ladite couche organique de transport de charges ne présente pas de caractère bipolaire. La molécule élémentaire du matériau de base de ladite couche organique de transport de charges ne présente pas de caractère bipolaire en ce sens qu'elle ne possède pas à la fois un groupement de type accepteur d'électrons et un groupement de type donneur d'électrons.

De préférence, le matériau de base de la couche organique électroluminescente ne présente pas de caractère bi-polaire, contrairement au matériau de base de la couche organique électroluminescente des diodes décrites dans le document US2006-131562, où toutes les couches organiques sont à base du même matériau bipolaire. La molécule élémentaire du matériau de base de ladite couche organique électroluminescente ne présente pas de caractère bipolaire en ce sens qu'elle ne possède pas à la fois un groupement de type accepteur d'électrons et un groupement de type donneur d'électrons. Selon l'invention :

- si ladite couche organique bipolaire est intercalée entre ladite couche électroluminescente avec laquelle elle est en contact et l'électrode servant de cathode, et si l'on appelle $E_{EL-V}$ le potentiel d'ionisation ou l'énergie du niveau du HOMO du matériau de base de la couche organique électroluminescente, et $E_{BP-V}$ le potentiel d'ionisation ou l'énergie du niveau du HOMO du matériau de base de la couche organique bipolaire, ces potentiels étant évalués positivement par rapport à l'énergie d'un électron dans le vide à l'infini, on a la relation : $|E_{BP-V} - E_{EL-V}| \leq 0{,}3$ eV ;
- et/ou si ladite couche organique bipolaire est intercalée entre ladite couche électroluminescente avec laquelle elle est en contact et l'électrode servant d'anode, et si l'on appelle $E_{EL-C}$ l'affinité électronique ou l'énergie du niveau du LUMO du matériau de base de la couche organique électroluminescente, et $E_{BP-C}$ l'affinité électronique ou l'énergie du niveau du LUMO du matériau de base de la couche organique bipolaire, ces potentiels étant évalués positivement par rapport à l'énergie d'un électron dans le vide à l'infini, on a la relation : $|E_{EL-C} - E_{BP-C}| \leq 0{,}3$ eV.

On limite alors, selon l'invention, la différence de potentiel à l'interface entre la couche organique électroluminescente et la couche organique bipolaire, ce qui évite l'accumulation à cette interface et limite les risques de détérioration du matériau de base de la couche électroluminescente ; on améliore sensiblement la durée de vie de la diode.

Les avantages d'une couche organique bipolaire adjacente à la couche organique électroluminescente sont les suivants :

- la couche organique bipolaire permet d'évacuer les charges excédentaires à l'interface avec la couche organique électroluminescente ;
- parallèlement, la couche organique bipolaire n'entrave pas l'injection des charges de signe opposé dans la couche organique électroluminescente ;
- les chemins de transports des charges de signes opposés étant décorrélés, il n'y a pas a priori de recombinaison dans la couche organique bipolaire, ce qui évite toute dégradation du rendement quantique.

De préférence, l'épaisseur de l'au moins une couche organique bipolaire est supérieure ou égale à 5 nm et inférieure ou égale à 15 nm. L'épaisseur minimum de 5 nm est généralement nécessaire pour obtenir la fonction de blocage de charges basée sur la mobilité et pour redistribuer efficacement les charges qui s'accumuleraient à l'interface. L'épaisseur maximum de 15 nm permet de limiter les pertes ohmiques.

Selon l'invention :

- si l'électrode au contact de laquelle se trouve la couche organique de transport de charge sert de cathode, et si l'on appelle $E_{EL-V}$ le potentiel d'ionisation ou l'énergie du niveau du HOMO du matériau de base de la couche organique électroluminescente, et $E_{TL-V}$ le potentiel d'ionisation ou l'énergie du niveau du HOMO du matériau de base de la couche organique de transport de charge, ces potentiels étant évalués positivement par rapport à l'énergie d'un électron dans le vide à l'infini, on a la relation : $E_{TL-V} > E_{EL-V}$
- et/ou si l'électrode au contact de laquelle se trouve la couche organique de transport de charge sert d'anode, et si l'on appelle $E_{EL-C}$ l'affinité électronique ou l'énergie du niveau du LUMO du matériau de base de la couche organique électroluminescente, et $E_{TL-C}$ l'affinité électronique ou l'énergie du niveau du LUMO du matériau de base de la couche organique de transport de charge, ces potentiels étant évalués positivement par rapport à l'énergie d'un électron dans le vide à l'infini, on a la relation : $E_{TL-C} < E_{EL-C}$.

La fonction de blocage des charges est alors avantageusement répartie entre la couche organique bipolaire et la couche de transport de charges.

De préférence, le matériau de base de la couche organique de transport de charge est dopé n ou p, et le matériau de base de la couche organique bipolaire n'est ni dopé n, ni dopé p. Si l'électrode au contact de laquelle se trouve la couche organique de transport de charge sert de cathode, le matériau de base de la couche organique de transport de charge est alors dopé n, c'est-à-dire en éléments donneurs d'électrons ; si l'électrode au contact de laquelle se trouve la couche organique de transport de charge sert d'anode, le matériau de base de la couche organique de transport de charge est alors dopé p, c'est-à-dire en éléments accepteurs. L'utilisation d'un matériau dopé pour la couche de transport permet de réaliser des couches de transport ayant des épaisseurs sensiblement élevées tout en limitant les pertes ohmiques ; le fait que le matériau de base de la couche bipolaire ne soit pas dopé n ou p permet d'éviter les risques de contamination du matériau de la couche organique électroluminescente par le dopant de la couche de transport ; de préférence, l'épaisseur de la couche organique bipolaire est alors supérieure ou égale à 5 nm pour limiter les risques de diffusion du dopant, et inférieure ou égale à 15 nm pour limiter les pertes ohmiques.

De préférence, la molécule élémentaire du matériau de base de la couche organique bipolaire est saturée en doubles liaisons C=C. En effet, la plupart des molécules organiques saturées en doubles liaisons C=C possèdent en effet un caractère bipolaire.

De préférence, le matériau de base de la couche organique bipolaire est choisi dans le groupe formé par le TAND et le TAZ-TPA. Comme matériau de base de la couche organique bipolaire, on peut par exemple utiliser le TAND, qui correspond à N-(p-(di-p-tolylamino)phenyl)-N-(1,2-dimethylpropyl)-1,4,5,8-naphthalenetetracarboxylic diimide, qui est décrit dans l'article intitulé « A Bipolar Charge Transport Molecule », de B.J. MURRAY et al., publié en 1996 dans la revue Japan Journal of Applied Physics, vol. 35, pp 5384-5388. Comme matériau de base de la couche organique bipolaire, on peut également utiliser le TAZ-TPA décrit dans l'article intitulé « Highly electroluminescent devices made with a conveniently synthetized triazole-triphenylamine derivative », de T. MAINDRON et al., publié dans la revue Thin Solid Films en 2004 (Maindron, T. et al. Thin Solid Films, Volume 466, Issues 1-2, 1 November 2004, Pages 209-216). La molécule TAZ-TPA est bipolaire parce qu'elle possède un groupement triazole (TAZ) pour le transport des électrons et un groupement amine (TPA) pour le transport des trous ; Les deux groupements sont reliées par une double liaison C=C, qu'on appelle « le chromophore ». L'avantage principal de ces matériaux comme le TAND et le TAZ-TPA réside en général dans leur stabilité « électrochimique » puisqu'un matériau bipolaire est sensé être stable en réduction et en oxydation. Les matériaux TAND et TAZ-TPA qui viennent d'être cités présentent avantageusement un type particulier de conduction électrique, puisque les niveaux de transports respectifs des deux types de charges, électrons et trous, sont découplés l'un de l'autre ; ce phénomène de découplage est connu sous le nom de « formalisme du désordre de Bässler ». Selon une variante, non inventive, le matériau de base de l'au moins une couche bipolaire est formé par un mélange d'un matériau dont la molécule élémentaire possède un groupement accepteur d'électrons et d'un matériau dont la molécule élémentaire possède un groupement donneur d'électrons. La couche organique bipolaire peut alors être obtenue par exemple en mélangeant, par exemple par coévaporation, les matériaux AIQ3 et NPB ; l'avantage de cette méthode est de pouvoir contrôler la proportion des deux composantes et de mieux optimiser ainsi à la fois l'efficacité d'émission et la durée de vie de la diode.

L'invention a également pour objet un panneau d'affichage d'images comprenant un réseau de diodes selon l'invention dont lesdites diodes sont, de préférence, supportées par un même substrat.

L'invention sera mieux comprise à la lecture de la description qui va suivre, donnée à titre d'exemple non limitatif, et en référence aux figures annexées sur lesquelles :

- la figure 1 illustre un mode de réalisation d'une diode selon l'invention ;
- la figure 2 illustre la durée de vie d'une diode selon l'invention comparé à celui d'une diode selon l'art antérieur ne se différentiant avec la précédente qu'au niveau de la couche de blocage de trous ; la durée de vie est évaluée par mesure de l'intensité lumineuse émise par la diode en fonction du temps, pour un courant donné traversant cette diode.

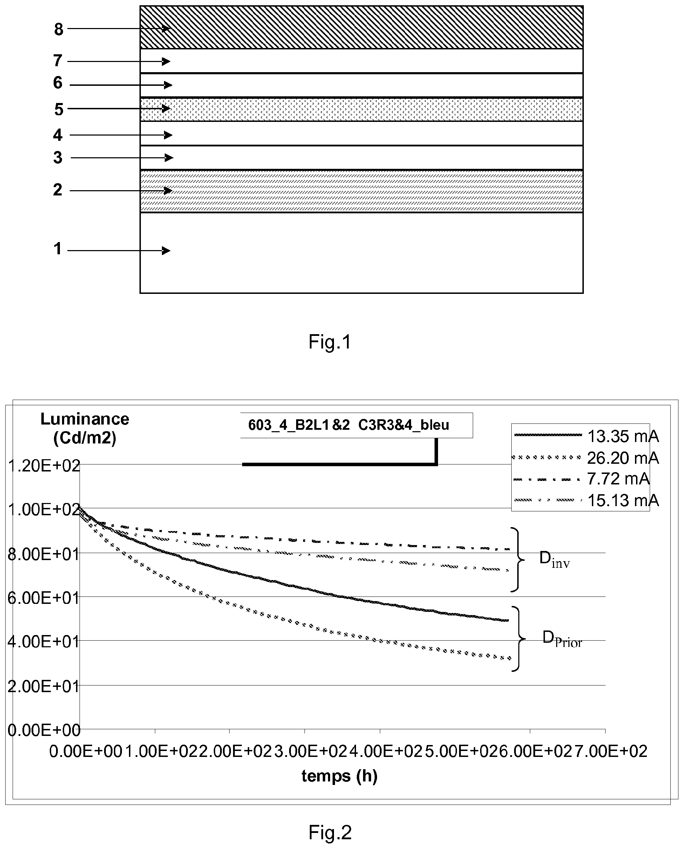

En référence à la figure 1, on va maintenant décrire un mode de réalisation d'une diode selon l'invention ; les différentes couches de cette structure peuvent être obtenus par des moyens connus en eux-mêmes qui ne seront pas décrits ici en détail :

- une électrode inférieure 2, transparente et servant d'anode, est déposée sur un substrat 1 ; comme matériau de base de cette électrode 2, on peut par exemple utiliser de l'ITO ; l'épaisseur typique de l'électrode 2 est de 150 nm ;

- ensuite, on dépose une couche de transport de trous 3, assurant également l'injection des trous ; on utilise de préférence un conducteur organique de trous (tel que le PEDOT-PSS, comme par exemple décrit pour une telle couche d'injection et de transport de trous dans les documents EP0727100, US6586764 et US2004/095064), ou un semi-conducteur organique (par exemple un semi-conducteur à base d'amines) dopé en dopant de type p (par exemple le TCNQ, NDP2, F4TCNQ). Grâce au caractère conducteur ou semi-conducteur dopé, la couche 3 peut présenter une épaisseur relativement élevée, généralement comprise entre 30 et 200 nm ;
- puis, on dépose ensuite une couche de blocage d'électrons 4, qui est apte à transporter les trous ; le matériau de base de cette couche 4 est choisi d'une manière connue en elle-même pour bloquer les électrons, en référence, notamment, à son niveau de LUMO, comme dans l'art antérieur cité auparavant ; ce matériau de base n'est pas dopé n ou p et ne contient pas d'agent complexant ; comme ce matériau présente alors une faible conductivité, on n'en dépose qu'une faible épaisseur, généralement inférieure à 10 nm, de manière à limiter les pertes ohmiques ; pour cette couche 4, on peut notamment utiliser un film de Spiro-TAD ou de NPB d'épaisseur 7 nm ;
- s'ensuit le dépôt d'une couche organique électroluminescente 5 susceptible d'émettre un rayonnement de teinte rouge, bleu ou vert selon la couleur d'émission désirée. Les matériaux utilisés peuvent être de type polymère, ou petites molécules. Pour illustration, l'émission rouge peut être obtenue à partir d'un matériau de base tel que le TMM-004 (Covion 2004) dopé à 15% en poids par un dopant phosphorescent dénommé en 2004 « TER-004 » ; en variante, on peut aussi utiliser le matériau de base Alq3 dopé par du DCM2. L'épaisseur de cette couche 5 est typiquement de l'ordre de 30 nm ;
- par un procédé analogue au précédent, on dépose ensuite une couche organique bipolaire 6 selon l'invention, servant notamment au blocage des trous ; selon l'invention, on choisit un matériau présentant une forte mobilité pour les électrons et une faible mobilité pour les trous ;
- enfin, on dépose une couche de transport d'électrons 7, assurant également l'injection des électrons. La couche 7 est à base d'un même matériau semi-conducteur organique dopable n, qui est ici en outre adapté au blocage des trous par création classique d'une barrière de potentiel pour les trous. On peut ainsi utiliser du Bphen, abréviation correspondant au composé dénommé bathophénanthroline, ou, plus précisément, 4,7-diphenyl-1,10-phénanthroline. A à cet effet, on procède par co-évaporation sous vide de BPhen et de dopant n sur une épaisseur d'environ 35 nm, formant ainsi la couche de transport d'électrons 7. Le dopant de type n peut être un élément alcalin (tel que le césium), ou un alcalino-terreux (comme du calcium).
- finalement, on dépose d'une manière connue en elle-même une électrode supérieure réfléchissante 8, jouant le rôle de cathode ; on peut notamment utiliser à cet effet une épaisseur de 150 nm d'aluminium.

On obtient alors une diode selon l'invention.

La couche organique bipolaire 6 est donc au contact de la face supérieure de la couche électroluminescente 5 ; elle est donc ici intercalée entre la couche électroluminescente 5 avec laquelle elle est en contact et l'électrode supérieure 8 servant de cathode ; si l'on appelle $E_{EL-V}$ le potentiel d'ionisation ou l'énergie du niveau du HOMO du matériau de base de la couche organique électroluminescente 5, et $E_{TL-V}$ le potentiel d'ionisation ou l'énergie du niveau du HOMO du matériau de base de la couche de transport d'électrons 7, ces potentiels étant évalués positivement par rapport à l'énergie d'un électron dans le vide à l'infini, de manière à obtenir la fonction de blocage des trous, ces matériaux sont choisis d'une manière connue en elle-même de manière à obtenir la relation : $E_{TL-V} > E_{EL-V}$.

Selon l'invention, la couche classique de blocage de trous est donc remplacée par une couche organique bipolaire 6 dont la fonction est en outre de limiter la densité de charges à l'interface entre la couche organique électroluminescente 5 et la couche organique bipolaire 6 ; on limite ainsi les risques de dégradation prématurée de la couche organique électroluminescente et la durée de vie de la diode ainsi obtenue est sensiblement plus élevée que celle des diodes comparables de l'art antérieur.

Les exemples suivants illustrent l'invention pour des matériaux spécifiques des couches organiques.

Exemple 1 :

Cet exemple a pour but d'illustrer un premier cas d'utilisation d'une couche organique bipolaire à base de TAND ; selon le mode de réalisation qui vient d'être décrit, on réalise l'empilement suivant : 2 : ITO/ 3 : sTTB+NDP2 / 4 : NPB / 5 : EML / **6 : TAND** / 7 : BPhen+TND1 / 8 : Al.

F4TCNQ et TND1 sont des dopants électriques respectivement accepteur et donneur d'électrons ; le matériau de base de l'EML (« Electroluminescent Layer ») est dopé d'un dopant fluorescent ou non dopé ; les valeurs de $E_{BP-V}$, $E_{EL-V}$ vérifient la relation : $E_{BP-V} \geq E_{EL-V}$.

Exemple 2 :

Cet exemple a pour but d'illustrer un deuxième cas d'utilisation d'une couche organique bipolaire à base ici de TAZ-TPA ; selon le mode de réalisation qui vient d'être décrit, on réalise l'empilement suivant : 2 : ITO/ 3 : sTTB+NDP2 / 4 : NPB / 5 : EML / **6' : TAZ-TPA** / 7 : BPhen+TND1 / 8 : Al.
Le matériau de base de l'EML (« Electroluminescent Layer ») est dopé par un dopant fluorescent ou phosphorescent ; les valeurs de $E'_{BP-V}$, $E_{EL-V}$ vérifient la relation : $E'_{BP-V} \geq E_{EL-V}$.

Exemple 3 (non inventif) :

Cet exemple a pour but d'illustrer un troisième cas d'utilisation d'une couche organique bipolaire à base ici d'un mélange 50-50 d'un matériau dont la molécule élémentaire possède un groupement accepteur d'électrons (ici NPB) et d'un matériau dont la molécule élémentaire possède un groupement donneur d'électrons (ici AIQ3) ; selon le mode de réalisation qui vient d'être décrit, on réalise l'empilement suivant : 2 : ITO/ 3 : sTTB+NDP2 / 4 : NPB / 5 : EML / **6'' : AIQ3 :NPB** / 7 : BPhen+TND1 / 8 : Al.
Le matériau de base de l'EML (« Electroluminescent Layer ») est dopé par un dopant fluorescent ou phosphorescent ; les valeurs de $E'_{BP-V}$, $E_{EL-V}$ vérifient la relation : $E''_{BP-V} \geq E_{EL-V}$.

Exemple 4 (non inventif) :

La figure 2 illustre des tests de vieillissement accéléré aux luminances de 800 et 1600 cd/m2 de deux diodes ne se différenciant que par leur couche de blocage des électrons :

- la première $D_{BPhen}$, selon l'art antérieur, présente la structure suivante : ITO/HTL dopé p (35nm)/NPB/EML Bleue (30nm)/**Bphen (5nm)**/ ETL dopée n (30nm)/Al) ;
- la deuxième $D_{Alq3}$, présente la structure suivante : ITO/HTL dopé p (35nm)/NPB/EML Bleue (30nm)/**Alq3 (5nm)**/ ETL dopée n (30nm)/Al).

On évalue la durée de vie de ces diodes par mesure de leur intensité lumineuse en fonction du temps, pour un courant donné traversant cette diode : 13,35 mA et 26,20 mA pour la diode selon l'art antérieur $D_{BPhen}$, 7,72 mA et 15,13 mA pour la deuxième diode $D_{Alq3}$. Comme l'indique la figure 2, la première diode se dégrade plus rapidement que la seconde ; une telle différence de vieillissement est attribué à la différence concernant la barrière de potentiel à l'interface entre la couche de blocage des trous (HBL) et la couche électroluminescente (EML) ; en effet, un dopage efficace ($\Delta E=0,3eV$, comme assuré par le système EML/Bphen) implique une accumulation de trous, qui tend à détériorer l'émetteur bleu de la couche électroluminescente et/ou l'interface entre la couche de blocage des trous (HBL= BPhen) et la couche électroluminescente (EML). Au contraire, en remplaçant le BPhen par l'AIQ3 comme matériau pour la couche de blocage des trous (HBL), comme la juxtaposition du matériau de la couche électroluminescente (EML) et de l'Alq3 ne crée aucune barrière de potentiel significative ($LUMO_{EML} \sim LUMO_{Alq3}$), aucune accumulation de trous ne vient altérer la qualité de l'émetteur bleu et/ou l'interface entre la couche de blocage des trous (HBL= AIQ3) et la couche électroluminescente (EML).

**Revendications**

1.  Diode organique électroluminescente comprenant :

    - une électrode inférieure (2) et une électrode supérieure (8), l'une (2) desdites électrodes servant d'anode et l'autre (8) servant de cathode,
    - au moins une couche organique électroluminescente (5) intercalée entre ces deux électrodes,
    - au moins une couche organique bipolaire (6) qui est au contact d'au moins une des faces de l'au moins une couche électroluminescente (5) et qui est intercalée entre cette couche électroluminescente (5) et l'une (8) desdites électrodes,
    - et une couche organique de transport de charges (7) qui est intercalée entre ladite électrode (8) et l'au moins une couche organique bipolaire (6), où la molécule élémentaire du matériau de base de l'au moins une couche organique bipolaire (6) possède à la fois un groupement de type accepteur d'électrons et un groupement de type donneur d'électrons,

    **caractérisé en ce que** :

- si l'au moins une couche organique bipolaire (6) est intercalée entre ladite couche électroluminescente (5) avec laquelle elle est en contact et l'électrode (8) servant de cathode, alors le matériau de base de ladite couche organique bipolaire (6) présente une mobilité plus faible pour les trous que pour les électrons, et si l'on appelle $E_{EL-V}$ le potentiel d'ionisation ou l'énergie du niveau du HOMO du matériau de base de la couche organique électroluminescente (5), $E_{BP-V}$ le potentiel d'ionisation ou l'énergie du niveau du HOMO du matériau de base de la couche organique bipolaire (6), et $E_{TL-V}$ le potentiel d'ionisation ou l'énergie du niveau du HOMO du matériau de base de la couche organique de transport de charge (7), ces potentiels étant évalués positivement par rapport à l'énergie d'un électron dans le vide à l'infini, alors on a les relations : $|E_{BP-V} - E_{EL-V}| \leq 0,3$ eV et $E_{TL-V} > E_{EL-V}$ ;

- et/ou si l'au moins une couche organique bipolaire est intercalée entre ladite couche électroluminescente avec laquelle elle est en contact et l'électrode servant d'anode, alors le matériau de base de ladite couche organique bipolaire présente une mobilité plus faible pour les électrons que pour les trous, et si l'on appelle $E_{EL-C}$ l'affinité électronique ou l'énergie du niveau du LUMO du matériau de base de la couche organique électroluminescente, $E_{BP-C}$ l'affinité électronique ou l'énergie du niveau du LUMO du matériau de base de la couche organique bipolaire, et $E_{TL-C}$ l'affinité électronique ou l'énergie du niveau du LUMO du matériau de base de la couche organique de transport de charge, ces potentiels étant évalués positivement par rapport à l'énergie d'un électron dans le vide à l'infini, alors on a les relations : $|E_{EL-C} - E_{BP-C}| \leq 0,3$ eV et $E_{TL-C} < E_{EL-C}$.

2. Diode selon la revendication 1 **caractérisée en ce que** le matériau de base de ladite couche organique de transport de charges (7) ne présente pas de caractère bipolaire.

3. Diode selon la revendication 1 ou 2 **caractérisée en ce que** le matériau de base de la couche organique électroluminescente ne présente pas de caractère bi-polaire.

4. Diode selon l'une quelconque des revendications précédentes **caractérisée en ce que** l'épaisseur de l'au moins une couche organique bipolaire est supérieure ou égale à 5 nm et inférieure ou égale à 15 nm.

5. Diode selon l'une quelconque des revendications précédentes **caractérisée en ce que** le matériau de base de la couche organique de transport de charge (7) est dopé n ou p, et **en ce que** le matériau de base de la couche organique bipolaire (6) n'est ni dopé n, ni dopé p.

6. Diode selon l'une quelconque des revendications 1 à 5 **caractérisée en ce que** la molécule élémentaire du matériau de base de l'au moins une couche organique bipolaire est saturée en doubles liaisons C=C.

7. Diode selon l'une quelconque des revendications 1 à 5 **caractérisée en ce que** le matériau de base de la couche organique bipolaire est choisi dans le groupe formé par le TAND (N-(p-(di-p-tolylamine)phenyl)-N'-(1,2-dimethylpropyl)-1,4,5,8-naphthalenetetracarboxylic diimide) et le TAZ-TPA (triazole-triphenylamine).

8. Panneau d'affichage d'images comprenant un réseau de diodes selon l'une quelconque des revendications précédentes.

**Patentansprüche**

1. Organische Leuchtdiode, die umfasst:

   - eine untere Elektrode (2) und eine obere Elektrode (8), wobei eine (2) der besagten Elektroden als Anode dient und die andere (8) als Kathode dient,
   - mindestens eine organische Leuchtschicht (5), die zwischen diesen beiden Elektroden angeordnet ist,
   - mindestens eine organische bipolare Schicht (6), die im Kontakt mit mindestens einer der Seiten der mindestens einen Leuchtschicht (5) ist und die zwischen dieser Leuchtschicht (5) und einer (8) der besagten Elektroden angeordnet ist,
   - und eine organische Schicht zum Transportieren von Ladungen (7), die zwischen der besagten Elektrode (8) und der mindestens einen organischen bipolaren Schicht (6) angeordnet ist, wo das elementare Molekül des Ausgangsmaterials der mindestens einen organischen bipolaren Schicht (6) gleichzeitig eine Gruppe vom Typ Elektronenakzeptor und eine Gruppe vom Typ Elektronendonator besitzt, **dadurch gekennzeichnet, dass**:

      - wenn die mindestens eine organische bipolare Schicht (6) zwischen der besagten Leuchtschicht (5), mit welcher sie in Kontakt ist, und der Elektrode (8), die als Kathode dient, angeordnet ist, dann weist das Ausgangsmaterial der besagten organischen bipolaren Schicht (6) eine schwächere Mobilität für die Löcher als für die Elektronen auf, und wenn man $E_{EL-V}$ als das Ionisationspotenzial oder als die Energie des Niveaus des HOMO des Ausgangsmaterials der organischen Leuchtschicht (5) bezeichnet, $E_{BP-V}$ als das Ionisationspotential oder die Energie des Niveaus des HOMO des Ausgangsmaterials der organischen bipolaren Schicht (6), und $E_{TL-V}$ als das Ionisationspotential oder die Energie des Niveaus des HOMO des Ausgangsmaterials der organischen Ladungstransportschicht (7), diese Potentiale bezogen auf die Energie eines Elektrons im unbegrenzten Vakuum positiv beurteilt werden, dann hat man die Gleichungen:

$$|E_{BP-V} - E_{EL-V}| \leq 0,3 \text{ eV und } E_{TL-V} > E_{EL-V},$$

- und/oder wenn die mindestens eine organische bipolare Schicht zwischen der besagten Leuchtschicht, mit welcher sie in Kontakt ist, und der Elektrode, die als Anode dient, angeordnet ist, dann weist das Ausgangsmaterial der besagten organischen bipolaren Schicht eine schwächere Mobilität für die Elektronen als für die Löcher auf, und wenn man $E_{EL-C}$ als die Elektronenaffinität oder die Energie des Niveaus des LUMO des Ausgangsmaterials der organischen Leuchtschicht bezeichnet, $E_{BP-C}$ als die Elektronenaffinität oder die Energie des Niveaus des LUMO des Ausgangsmaterials der organischen bipolaren Schicht, und $E_{TL-C}$ als die Elektronenaffinität oder die Energie des Niveaus des LUMO des Ausgangsmaterials der organischen Ladungstransportschicht, diese Potentiale bezogen auf die Energie eines Elektrons im unbegrenzten Vakuum positiv beurteilt werden, dann hat man die Gleichungen:

$$|E_{EL-C} - E_{BP-C}| \leq 0,3 \text{ eV und } E_{TL-C} < E_{EL-C}.$$

2. Diode nach Anspruch 1, **dadurch gekennzeichnet, dass** das Ausgangsmaterial der besagten organischen Ladungstransportschicht (7) keinen bipolaren Charakter aufweist.

3. Diode nach Anspruch 1 oder 2, **dadurch gekennzeichnet, dass** das Ausgangsmaterial der organischen Leuchtschicht keinen bipolaren Charakter aufweist.

4. Diode nach einem der vorstehenden Ansprüche, **dadurch gekennzeichnet, dass** die Dicke der mindestens einen organischen bipolaren Schicht mindestens 5 nm und höchstens 15 nm beträgt.

5. Diode nach einem der vorstehenden Ansprüche, **dadurch gekennzeichnet, dass** das Ausgangsmaterial der organischen Ladungstransportschicht (7) n- oder p-dotiert ist, und dadurch, dass das Ausgangsmaterial der organischen bipolaren Schicht (6) weder n- noch p-dotiert ist.

6. Diode nach einem der Ansprüche 1 bis 5, **dadurch gekennzeichnet, dass** das elementare Molekül des Ausgangsmaterials der mindestens einen organischen bipolaren Schicht in Doppelbindungen C=C gesättigt ist.

7. Diode nach einem der Ansprüche 1 bis 5, **dadurch gekennzeichnet, dass** das Ausgangsmaterial der organischen bipolaren Schicht ausgewählt wird aus der Gruppe, die gebildet ist durch TAND (N-(p-(Di-p-tolylamin)phenyl)-N'-(1,2-Dimethylpropyl)-Naphthalen-1,4,5,8-tetracarboxyldiimid) und TAZ-TPA (Triazol-Triphenylamin).

8. Tafel zum Anzeigen von Bildern, die eine Anordnung von Dioden nach einem der vorstehenden Ansprüche umfasst.

## Claims

1. Organic light-emitting diode comprising:

    - a lower electrode (2) and an upper electrode (8), the one (2) of said electrodes acting as anode and the other (8) acting as cathode,
    - at least one organic light-emitting layer (5) interposed between these two electrodes,
    - at least one bipolar organic layer (6) that is in contact with at least one of the faces of the at least one light-emitting layer (5) and that is interposed between this light-emitting layer (5) and the one (8) of said electrodes,
    - and an organic charge transport layer (7) that is interposed between said electrode (8) and the at least one bipolar organic layer (6), where the elementary molecule of the base material of the at least one bipolar organic layer (6) has both an electron acceptor group and an electron donor group, **characterised in that**:

- if the at least one bipolar organic layer (6) is interposed between said light-emitting layer (5) with which it is in contact and the electrode (8) acting as cathode, then the base material of said bipolar organic layer (6) has a lower mobility for the holes than for the electrons, and if $E_{EL-V}$ is called the ionisation potential or the energy of the HOMO level of the base material of the organic light-emitting layer (5), $E_{BP-V}$ the ionisation potential or the energy of the HOMO level of the base material of the bipolar organic layer (6), and $E_{TL-V}$ the ionisation potential or the energy of the HOMO level of the base material of the organic charge transport layer (7), these potentials being evaluated positively in relation to the energy of an electron in an infinite vacuum, then there are the following relationships: $|E_{BP-V} - E_{EL-V}| \leq 0.3$ eV and $E_{TL-V} > E_{EL-V}$,

- and/or if the at least one bipolar organic layer is interposed between said light-emitting layer with which it is in contact and the electrode acting as anode, then the base material of said bipolar organic layer has a lower mobility for the electrons than for the holes, and if $E_{EL-C}$ is called the electronic affinity or the energy of the LUMO level of the base material of the organic light-emitting layer, $E_{BP-C}$ the electronic affinity or the energy of the LUMO level of the base material of the bipolar organic layer, and $E_{TL-C}$ the electronic affinity or the energy of the LUMO level of the base material of the organic charge transport layer, these potentials being evaluated positively in relation to the energy of an electron in an infinite vacuum, then there are the following relationships: $|E_{EL-C} - E_{BP-C}| \leq 0.3$ eV and $E_{TL-c} < E_{EL-c}$.

2. Diode according to claim 1, **characterised in that** the base material of said organic charge transport layer (7) does not have a bipolar character.

3. Diode according to claim 1 or 2, **characterised in that** the base material of the organic light-emitting layer does not have a bipolar character.

4. Diode according to any one of the preceding claims, **characterised in that** the thickness of the at least one bipolar organic layer is greater than or equal to 5 nm and less than or equal to 15 nm.

5. Diode according to any one of the preceding claims, **characterised in that** the base material of the organic charge transport layer (7) is n- or p-doped, and **in that** the base material of the bipolar organic layer (6) is neither n-doped, nor p-doped.

6. Diode according to any one of claims 1 to 5, **characterised in that** the base elementary molecule of the at least one bipolar organic layer is saturated in C=C double bonds.

7. Diode according to any one of claims 1 to 5, **characterised in that** the base material of the bipolar organic layer is selected from the group formed by the TAND (N-(p-(di-p-tolylamine)phenyl)-N'-(1,2-dimethylpropyl)-1,4,5,8-naphthalenetetracarboxylic diimide) and the TAZ-TPA (triazole-triphenylamine).

8. Image display panel comprising a network of diodes according to any one of the preceding claims.

Fig.1

Fig.2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1065737 A
- EP 1220340 A
- US 5895692 A
- EP 1670083 A
- US 2004265624 A
- WO 2004075603 A
- US 2006131562 A
- JP 10152677 B
- EP 0727100 A
- US 6586764 B
- US 2004095064 A

**Littérature non-brevet citée dans la description**

- *Science,* 1999, vol. 283 (5409), 1900-1902
- **AZIZ, H. ; POPOVIC, Z. D.** *Chem. Mater.,* 2004, vol. 16 (23), 4522-4532
- **VI-EN CHOONG et al.** Organic light-emitting diodes with a bipolar transport layer. *Applied Physics Letters,* 12 Juillet 1999, vol. 75 (2), 172-174
- **B.J. MURRAY et al.** A Bipolar Charge Transport Molecule. *Japan Journal of Applied Physics,* 1996, vol. 35, 5384-5388
- **T. MAINDRON et al.** Highly electroluminescent devices made with a conveniently synthetized triazole-triphenylamine derivative. *Thin Solid Films,* 2004
- **MAINDRON, T. et al.** *Thin Solid Films,* 01 Novembre 2004, vol. 466 (1-2), 209-216